# EUROPEAN PATENT SPECIFICATION

(11) **EP 0 718 664 B1**
(45) Date of publication and mention of the grant of the patent: **14.03.2001**
(21) Application number: 95309428.1
(22) Date of filing: 22.12.1995
(51) Int. Cl.: G02F 1/1335

(54) **Manufacturing method of colour liquid crystal display**
Herstellungsverfahren einer Flussigkristall-Farbanzeigevorrichtung
Procédé de fabrication d'un affichage à cristal liquide en couleurs

(30) Priority: 22.12.1994 JP 32098994
(43) Date of publication of application: 26.06.1996
(60) Divisional application: 99201345.8
(73) Proprietor: SEIKO INSTRUMENTS INC., Chiba-shi, Chiba 261 (JP); SHINTO PAINT COMPANY, LIMITED, Amagasaki-shi Hyogo 661 (JP)
(72) Inventor: Suginoya, Mitsuru, c/o Seiko Instruments Inc., Chiba-shi, Chiba (JP); Motte, Shunichi, c/o Seiko Instruments Inc., Chiba-shi, Chiba (JP); Fukuchi, Takakazu, c/o Seiko Instruments Inc., Chiba-shi, Chiba (JP); Kamamori, Hitoshi, c/o Seiko Instruments Inc., Chiba-shi, Chiba (JP); Okada, Yoshikatsu,s c/o Shinto Paint Co. Ltd., Amagasaki-shi, Hyogo (JP); Sakurai, Akiko,s c/o Shinto Paint Co. Ltd., Amagasaki-shi, Hyogo (JP)
(74) Representative: Sturt, Clifford Mark

(56) References cited:
- EP-A- 0 572 672
- EP-A- 0 674 208
- PATENT ABSTRACTS OF JAPAN vol. 11, no. 129 (P-570) & JP 61 272720 A (SEIKO)
- PATENT ABSTRACTS OF JAPAN vol. 13, no. 426 (P-935) & JP 01 158401 A (FUJITSU)
- PATENT ABSTRACTS OF JAPAN vol. 14, no. 264 (P-1057) & JP 02 073305 A (TOPPAN PRINTING)
- PATENT ABSTRACTS OF JAPAN vol. 17, no. 626 (P-1647) & JP 05 203807 A (SEIKO)
- PATENT ABSTRACTS OF JAPAN vol. 16, no. 197 (P-1350) & JP 04 030118 A (SHARP)
- PATENT ABSTRACTS OF JAPAN vol. 18, no. 688 (P-1849) & JP 06 273618 A (DAINIPPON PRINTING)

## Description

The present invention relates to a method for manufacturing a colour liquid crystal display in which colour liquid crystal display in which colour filters are applied, and more particularly, but not exclusively, to a simple method for manufacturing an active matrix colour liquid crystal display presenting a high image quality.

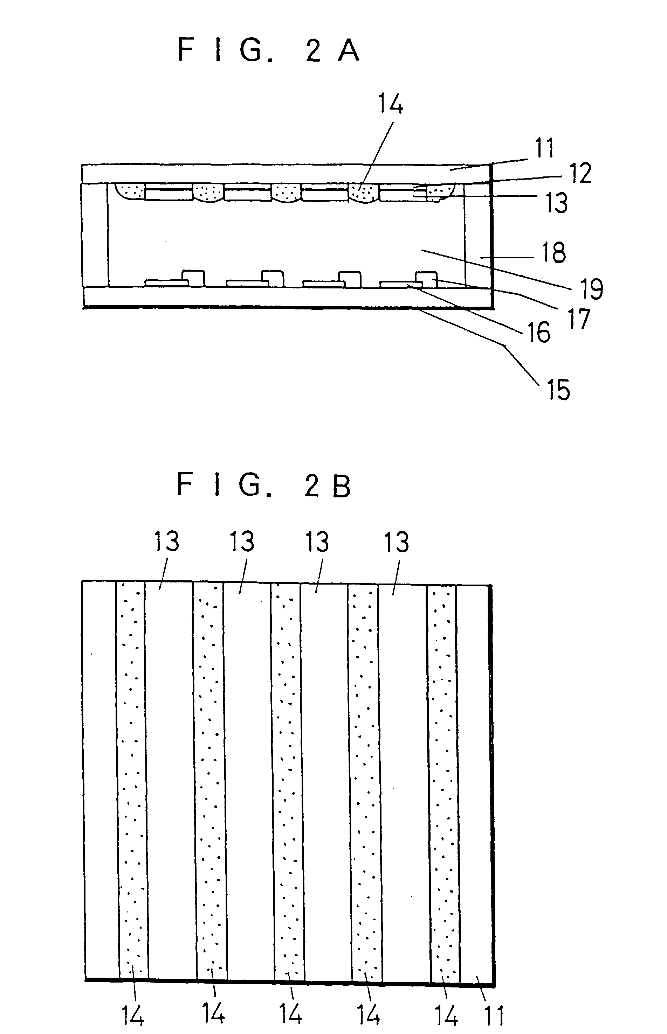

Figs. 2a and 2b are sectional and frontal views of a prior art colour liquid crystal display. In the figures, the reference numerals denote a glass substrate 11, transparent electrodes 12 composed of ITO or the like and patterned into stripes, colour filters 13 created on the transparent electrodes 12 by way of electro-deposition, light shielding layers 14 formed only in the gaps between colour filters by applying a photosensitive substance containing a light shielding substance such as carbon on the colour filters 13 and by exposing and developing it from the opposite side of the face where the colour filters are formed by utilising the colour filters as masks, and a second glass substrate 15 on which transparent electrodes 16 and thin film transistors 17 are formed. The colour liquid crystal display is formed by pasting the colour filter substrate 11 and the thin film transistor substrate 15 thus formed together by a sealing compound 18 so as to keep a predetermined gap therebetween and filling liquid crystal 19 in the gap.

The colour liquid crystal display thus formed has good contrast owing to switching characteristics of the thin film transistor, and the colour filters are formed simply by electro-deposition, so that a high quality and low cost colour display may be obtained.

However, although the colour liquid crystal display of the prior art is simple to make because the light shielding layer is formed in self-alignment utilising the colour filters as the masks, no light shielding layer is formed inevitably where there is the colour filter. Further, although the colour filter is simple to make because it is formed by way of electro-deposition, it requires a wiring for feeding electricity and the colour filter is inevitably formed at part where there is no pixel.

Thus, in the prior art display, the whole periphery of the pixel could not be surrounded by the light shielding layer. Further, although the display using the thin film transistor allowed a high contrast, its characteristics is apt to be changed by light, and it has been necessary to shield outside light to stabilise its operation.

Accordingly, it is desirable to eliminate the leakage of light from the periphery of the pixel, which had been unavoidable in the prior art method, to completely shield the periphery of the pixel. If this can be done, the operation of the thin film transistor may be stabilised and the contrast may be improved further as stray light is eliminated.

JP-A-1158401 discloses a process of forming a colour filter, wherein transparent electrodes are formed on an insulating substrate, and insulating film is formed over the substrate and electrodes, and removed selectively in two stages firstly to expose the electrodes to permit deposition and secondly between the color filters to permit deposition of light-shielding layers. The problem with this process is that the plural steps of removal of the insulating film may damage the colour filters.

According to the present invention, there is provided a method for manufacturing a multicolour liquid crystal display using colour filters comprising:
a step of forming and patterning a plurality of electrodes on a substrate;
a step of forming and patterning an insulative resist made of an alkali dissolution type agent on the plurality of electrodes;
a step of forming colour filters by selectively energising the plurality of electrodes to electro-deposit cationic polymers on the plurality of electrodes;
a step of removing the insulative resist made of an alkali dissolution agent from the plurality of electrodes by the alkali;
a step of forming a light shielding substance on the substrate; and
a step of exposing the light shielding substance from the opposite side of the substrate of which the colour filters are formed by utilising the colour filters as photo-masks for patterning the light shielding substance so as to be left on the parts where the colour filters are not formed.

By such a method, the periphery of the pixel of the colour display combined with a thin film transistor may be completely shielded and the leakage of light from the periphery of the pixel may be eliminated.

The point of the present invention, in one aspect, lies in that how dot-shaped colour filters separated from each other in an isolated manner can be formed by way of electro-deposition. It is necessary to coat insulative resist on a part of a pixel electrode so as not to cause electro-deposition on that part. A problem of this method, because the insulating resist is a useless layer when forming a light shielding layer later, is that of how the insulating layer should be handled so that it will not hamper the formation of the light shielding layer. One could attempt to remove the insulating resist without damaging the colour filters. However, because both the colour filter and the insulating resist are resin, it is difficult to remove selectively only one of them.

According to the present invention, a method of selecting an alkali as a peeling agent in peeling the insulating resin and of selecting a cationic resin as a resin to be electro-deposited was found. As a photoresist, generally there are solvent peeling type, alkali peeling type, nitric acid peeling type photoresists. In the solvent peeling, the colour filter resin is apt to cause a swelling and to be dissolved because a strong organic solvent is used. In the nitric acid peeling, because the resin is oxidised and decomposed, the colour filter resin is also oxidised and decomposed in the same manner. In the alkali peeling, the colour filter is not eroded in peeling and the insulating resin as long as a type of resin which is not neutralised and dissolved by alkali is selected as the colour filter resin because the peeling is carried out by neutral dissolution of a functional group of the resin.

As a typical photoresist, a phenolic novolak resin or the like is used as a positive resin and a substrate resin such as a synthetic rubber is used as a negative resin. While there are various types of peeling agents such as the alkali, nitric acid and solvent type peeling agents, the alkali dissolution type agent is commercially available.

As the electro-deposition, there are two types of resin of an anion type in which poly-carboxylic acid is neutralised by alkali such as amine and a cation type in which poly-amine is neutralised by acid. While the anion type is electro-deposited at the anode, the deposited film is essentially an alkali-soluble type film and the colour filters are eroded by the alkali when the insulating resin is peeled by the alkali after forming the colour filters by way of electro-deposition.

In contrast, in the cation type, because the colour filter is deposited at the cathode and the deposited film is essentially oxide-soluble and alkali-insoluble, the colour filters are not eroded when the insulating resin is peeled off by the alkali and the insulating resin can be peeled off readily. As the cation type electro-deposition resin, there are acrylic resin, epoxy resin, urethane resin, polybutadiene resin, polyamide resin and the like, and they are used singularly, in a mixed form or in combination with a bridging resin such as urethane resin and polyesther resin. All of the resins have a basic functional group such as amino group and an onium group such ammonium, sulfonium, phosfonium within the molecules and is used in a manner solubilized in water by acid or acid substance such as acetic acid, formic acid, propionic acid and lactic acid.

When the light shielding film is formed in self-alignment by utilising the colour filters as masks in the same manner with the prior art technology after forming the colour filters in accordance with a desired pixel shape, not in stripes, the light shielding film covers the whole periphery of the pixel, thus enchancing the light shielding performance and providing an excellent display quality.

For a better understanding of the invention embodiments will now be described, by way of example, with reference to the accompanying drawings, in which:-
Fig. 1 is a sectional view of a multicolour liquid crystal display which can be manufactured according to the method of the present invention;
Figs. 2a and 2b are section and frontal views of a prior art multicolour liquid crystal display;
Figs. 3a through 3d' are views showing a manufacturing process of a colour filter substrate which is not part of the invention as claimed; and
Figs. 4a through 4e' are views showing a manufacturing process of a colour filter substrate according to the present invention.

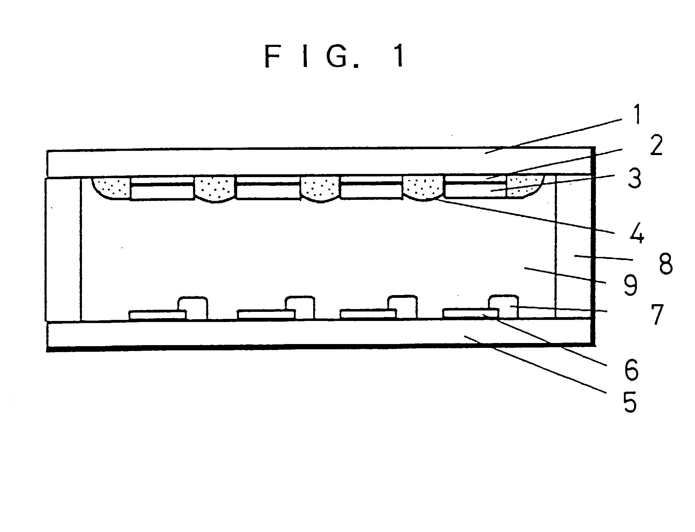

Fig. 1 shows a section view of a multicolour liquid crystal display which can be manufactured according to the method of the present invention. In the figure, the reference numerals denotes a glass substrate 1, transparent electrodes 2 composed of ITO or the like and patterned into stripes, colour filters 3 created on the transparent electrodes 2 by way of electro-deposition so that their shape coincides with a pixel, light shielding layers 4 formed by applying a photosensitive substance containing a light shielding substance such as carbon on the colour filters 3 and by exposing and developing it from the opposite side of the face where the colour filters are formed by utilising the colour filters as masks so that they cover the periphery of the colour filters.

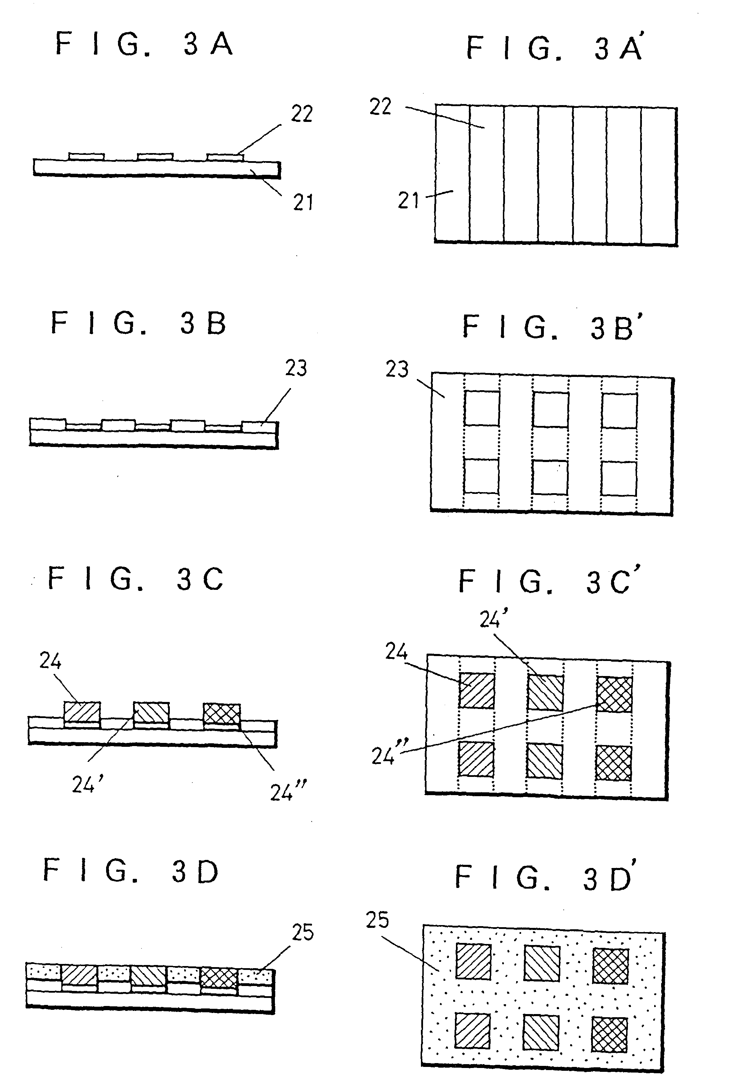

Figs. 3a through 3d' show a method for creating the above-mentioned colour filter substrate by section views and frontal views thereof.

In Figs. 3a and 3a', the reference numerals denote a glass substrate 21 and transparent electrodes 22 are formed in stripes by forming ITO and then patterning it.

In Figs. 3b and 3b', 0.1 µm of negative resist (V-259-PA, produced by Nippon Steel Chemical Co., Ltd.) was applied on the transparent electrodes 22. After that, it was exposed into a shape of desirable pixel and then developed by sodium carbonate solution to form insulating resists 23.

In Figs. 3c and 3c', a group of pixels to be coloured red was selected among the transparent electrodes 22, the transparent electrodes 22 anodised by an anionic polyester electro-deposition resin and dispersed solution of red pigment, and red colour filters 24 were formed by electro-deposition. Next, the same operation was repeated for green and blue to create colour filters 24' and 24" with 1.5 µm of thickness.

In Figs. 3d and 3d', a black resist in which carbon was mixed into negative resist (V-259-PA, produced by Nippon Steel Chemical Co., Ltd.) was applied to colour filters, was exposed from the back side utilising the colour filters as masks and was developed to form a light shielding film 25.

The colour filter substrate thus fabricated could be simply formed without being eroded by the strong alkali used in peeling off the insulating resist.

Returning to Fig. 1, the multicolour liquid crystal display is formed by pasting the colour filter substrate 1 thus formed in the manner completely shielding the periphery of the colour filter pixels and a second glass substrate 5 on which pixel transparent electrodes 6 and thin film transistors 7 are formed together by a sealing compound 8 so as to keep a predetermined gap therebetween and by filling liquid crystal 9 in the gap.

Even though the multicolour liquid crystal display is fabricated thus by the simple method, the periphery of the pixels is completely shielded and there is no degradation of the characteristic of the thin film transistor, thus showing a high display quality. Further, because the light shielding film has a difference in level of only 0.1 pm of the insulating resist, it allows a homogeneous orientation to be maintained, causing no orientation disorder.

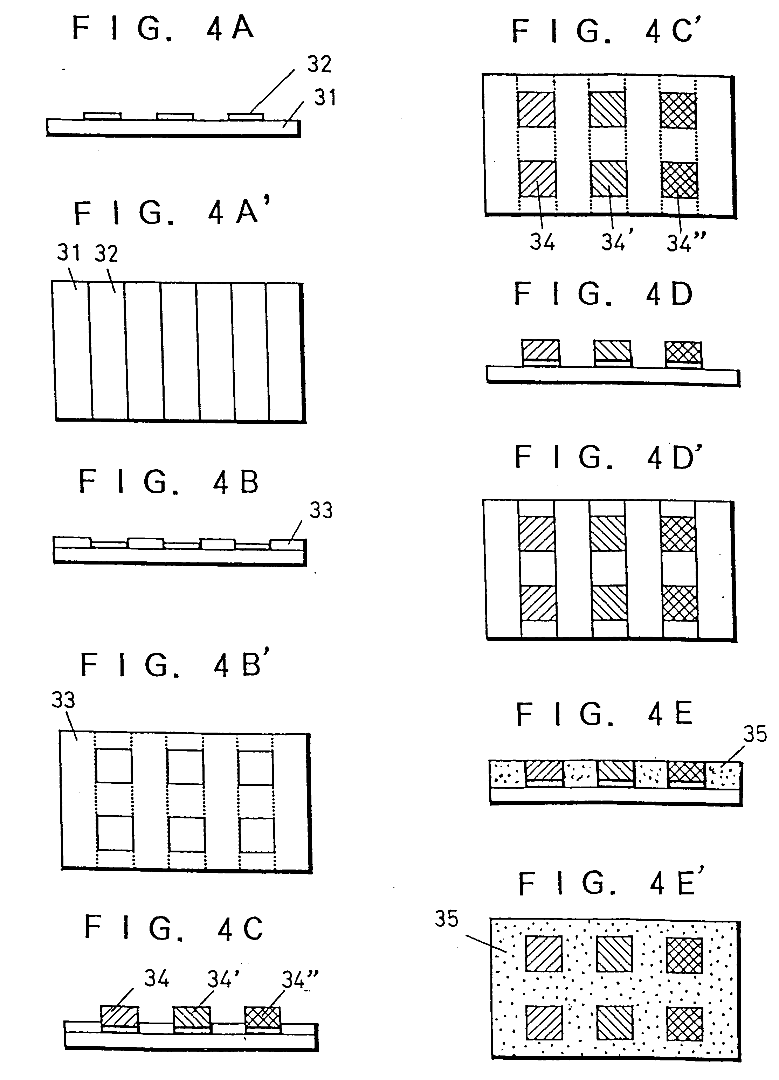

The colour filter substrate was fabricated by a method according to the invention shown in section views and frontal views in Figs. 4a through 4e'.

In Figs. 4a and 4a', the reference numeral 31 denotes a glass substrate, and transparent electrodes 32 are formed in stripes by forming ITO and then patterning it.

In Figs. 4b and 4b', 1 µm of positive resist (OFPR-800, produced by Tokyo Ohka Kogyo Co., Ltd.) was applied on the transparent electrode 32. After that, it was exposed in a shape of desirable pixel and then developed by sodium carbonate solution to form an insulating resist 33.

In Figs. 4c and 4c', a group of pixels to be coloured red was selected among the transparent electrodes 32, the transparent electrodes 32 was cathodized by a cationic acrylic electro-deposition resin and dispersed solution of red pigment, and red colour filters 34 were formed by way of electro-deposition. Next, the same operation was repeated for green and blue to create colour filters 34' and 34" with 1.5 µm of thickness.

In Figs. 4d and 4d', the insulating resist 33 was dissolved and peeled off by a strong alkali such as NaOH, KOH and tetramethylammonium hydroxide.

In Figs. 4e and 4e', a negative black resist (CK-5002, produced by Fuji-Hunt Electronics Technology Co., Ltd.) was applied on the colour filters, was exposed from the back side utilising the colour filters as masks and was developed to form a light shielding film 35.

Note that because alkali used in the development was much weaker than one used in peeling, the colour filter was not eroded as long as it had been hardened.

When the multicolour liquid crystal display was fabricated, the same effects as with the method of figure 3 could be obtained.

As explained in detail in the aforementioned, a method for manufacturing a multicolour liquid crystal display allows a periphery of pixels of a multicolour display combined with thin film transistors to be completely shielded and the leakage of light from the periphery of the pixels to be eliminated without hampering the advantages of the simple processes of forming colour filters by way of electro-deposition and of forming the light shielding film in self-alignment.

## Claims

1. A method for manufacturing a multicolour liquid crystal display using colour filters comprising:
a step of forming and patterning a plurality of electrodes on a substrate;
a step of forming and patterning an insulative resist made of an alkali dissolution type agent on the plurality of electrodes;
a step of forming colour filters by selectively energising the plurality of electrodes to electro-deposit cationic polymers on the plurality of electrodes;
a step of removing the insulative resist made of an alkali dissolution agent from the plurality of electrodes by the alkali;
a step of forming a light shielding substance on the substrate; and
a step of exposing the light shielding substance from the opposite side of the substrate of which the colour filters are formed by utilising the colour filters as photo-masks for patterning the light shielding substance so as to be left on the parts where the colour filters are not formed.

2. The method for manufacturing the multicolour liquid crystal display according to claim 1, wherein said light shielding substance has a photosensitivity.

3. The method for manufacturing the multicolour liquid crystal display according to claim 1 or 2, wherein said multicolour display applying said colour filters is an active matrix type display equipped with thin film transistors.

## Patentansprüche

1. Verfahren zur Herstellung einer Flüssigkristallmehrfarbenanzeige mit Farbfiltern, umfassend:
- einen Schritt zur Bildung und Strukturierung einer Mehrzahl von Elektroden auf einem Substrat,
- einen Schritt zur Bildung und Strukturierung eines aus einem alkalisch auflösbaren Mittel hergestellten Isolierresists auf der Mehrzahl von Elektroden,
- einen Schritt zur Bildung von Farbfiltern durch selektives Aktivieren der Mehrzahl von Elektroden, um kationische Polymere auf der Mehrzahl von Elektroden elektroabzuscheiden,
- einen Schritt zur Entfernung des aus dem alkalisch auflösbaren Mittel hergestellten Isolierresists von der Mehrzahl von Elektroden mittels des Akalis,
- einen Schritt zur Bildung einer Lichtabschirmungssubstanz auf dem Substrat und
- einen Schritt zur Belichtung der Lichtabschirmungssubstanz von der Seite des Substrats, die derjenigen gegenüberliegt, wo die Farbfilter gebildet sind, unter Nutzung der Farbfilter als Photomasken zur Stukturierung der Lichtabschirmungssubstanz, so daß diese an den Stellen verbleibt, wo die Farbfilter nicht gebildet sind.

2. Verfahren zur Herstellung der Flüssigkristallmehrfarbenanzeige nach Anspruch 1, wobei die Lichtabschirmungssubstanz eine Photoempfindlichkeit besitzt.

3. Verfahren zur Herstellung der Flüssigkristallmehrfarbenanzeige nach Anspruch 1 oder 2, wobei die Mehrfarbenanzeige mit den Farbfiltern eine mit Dünnfilmtransistoren ausgeführte Aktivmatrix-Anzeige ist.

## Revendications

1. Procédé de fabrication d'un dispositif d'affichage à cristaux liquides à plusieurs couleurs utilisant des filtres colorés, comprenant :
une étape de formation et de création de motifs d'une pluralité d'électrodes sur un substrat,
une étape de formation et de création de motifs, sur la pluralité d'électrodes, d'une réserve isolante constituée d'un agent du type se dissolvant dans un alcali,
une étape de formation de filtres colorés par excitation sélective de la pluralité d'électrodes pour déposer par électrodéposition des polymères cationiques sur la pluralité d'électrodes,
une étape d'enlèvement à l'aide de l'alcali, à partir de la pluralité d'électrodes, de la réserve isolante constituée de l'agent se dissolvant dans un alcali,
une étape de formation, sur le substrat, d'une substance arrêtant la lumière, et
une étape d'exposition de la substance arrêtant la lumière, à partir de la face opposée du substrat de laquelle les filtres colorés sont formés par utilisation des filtres colorés en tant que photomasques pour créer des motifs de la substance arrêtant la lumière de façon qu'elle reste sur les parties sur lesquelles les filtres colorés ne sont pas formés.

2. Procédé de fabrication d'un dispositif d'affichage à cristaux liquides à plusieurs couleurs selon la revendication 1, dans lequel ladite substance arrêtant la lumière présente une photosensibilité.

3. Procédé de fabrication d'un dispositif d'affichage à cristaux liquides à plusieurs couleurs selon la revendication 1 ou 2, dans lequel ledit dispositif d'affichage à plusieurs couleurs appliquant lesdits filtres colorés est un dispositif d'affichage du type matrice active équipé de transistors à couche mince.
